# FASCICULE DE BREVET EUROPEEN

(11) **EP 1 402 534 B1**
(45) Date de publication et mention de la délivrance du brevet: **14.05.2008**
(21) Numéro de dépôt: 02745518.7
(22) Date de dépôt: 12.06.2002
(51) Int. Cl.: G11C 16/10

(54) **PROCEDE DE PROGRAMMATION/REPROGRAMMATION PARALLELE DE MEMOIRE FLASH EMBARQUEE PAR BUS A ACCES MULTIPLES**
PARALLELES PROGRAMMIERUNGSVERFAHREN FÜR ONBOARD FLASHSPEICHER MITTELS EINES MEHRFACHZUGRIFFSBUSES
METHOD FOR PROGRAMMING/PARALLEL PROGRAMMING OF ONBOARD FLASH MEMORY BY MULTIPLE ACCESS BUS

(30) Priorité: 12.06.2001 FR 0107665
(43) Date de publication de la demande: 31.03.2004
(73) Titulaire: STMicroelectronics S.A., 92120 Montrouge (FR)
(72) Inventeur: ROGER, André, F-38340 Voreppe (FR); AUBENAS, Charles, F-38000 Grenoble (FR); FABREGUES, Julien, West Bloomfield, MI 48322 (US)
(74) Mandataire: Bentz, Jean-Paul
(86) Numéro de dépôt international: PCT/FR2002/002013
(87) Numéro de publication internationale: WO 2002/101752

(56) Documents cités:
- EP-A- 1 100 091
- WO-A-01/71439
- US-A- 5 430 859
- US-A- 5 974 499

## Description

La présente invention se rapporte à un procédé pour programmer et reprogrammer en parallèle toute mémoire embarquée reprogrammable via un bus à accès multiples tel qu'un bus fonctionnant selon le protocole CAN (acronyme pour l'expression anglo-saxonne Controller Area Network), et en particulier pour programmer et reprogrammer en parallèle des mémoires embarquées de type flash.

La description qui va suivre est en effet réalisée en référence à une mémoire de type flash, sans pour autant remettre en cause le concept de l'invention qui est généralisable à toute mémoire reprogrammable.

Il est également à noter que toute la description ci-après est faite plus particulièrement en référence à l'utilisation d'un bus CAN. Cependant, le concept de l'invention s'étend à la programmation/reprogrammation parallèle de flashs embarquées sur module via tout autre bus à accès mutliples non dédiés à cet effet et susceptibles d'être utilisés comme un substitut au CAN.

Les mémoires flash sont des mémoires EEPROM, acronyme pour l'expression anglo-saxonne Electrically Erasable Programmable Read-Only Memory, à temps d'écriture fortement réduit, à faible tension d'effacement et à grande capacité, est très employé dans les circuits microcontrôleurs, notamment les circuits dédiés à la gestion de la communication pour les divers outils de diagnostic d'un véhicule automobile, tels que le contrôle moteur, l'ABS, la gestion électronique des suspensions etc...

Le problème qui se pose alors est de programmer (ou reprogrammer) la mémoire embarquée de ces circuits dédiés en un minimum de temps et donc à coût réduit.

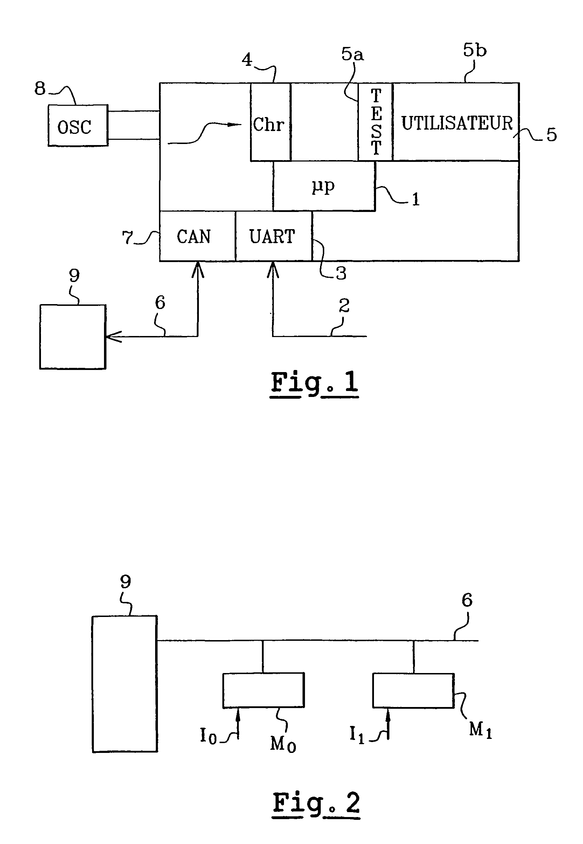

La figure 1 montre un schéma fonctionnel classique d'un module du type précité avec mémoire flash embarquée. Le coeur du circuit est constitué par un microprocesseur 1. Le microprocesseur 1 communique avec une unité centrale d'un ordinateur central par l'intermédiaire d'une liaison série asynchrone 2 de type UART, acronyme pour l'expression anglo-saxonne Universal Asynchronous Receiver-Transmitter. Une interface de transmission asynchrone 3 est alors montée entre le microprocesseur 1 et la la ligne de transmission 2 pour permettre la transmission de données en mode asynchrone. Un bus CAN peut également être prévu pour communiquer avec le microprocesseur via une interface CAN 7. Le circuit comprend encore un chronomètre 4 relié à un oscillateur externe 8 qui permet de déterminer la fréquence à laquelle tourne le système, et une mémoire effaçable et reprogrammable 5 de type mémoire flash. La mémoire flash est généralement partagée entre une zone test 5a et une zone utilisateur 5b.

Dans un contexte où les flash à programmer sont vierges, il importe de pouvoir démarrer l'activité du microprocesseur quelles que soient les conditions de fréquence à laquelle tourne le système et quelle que soit la vitesse de transmission.

Dans l'art antérieur, la méthodologie de démarrage qui permet d'activer la mémoire est basée sur le principe d'une séparation de la mémoire flash en deux parties : la partie test flash 5a et la partie flash utilisateur 5b. Ainsi, la test flash est programmée en usine avec un programme minimum qui permet alors de charger du code à travers la liaison série UART.

Cependant, la liaison série UART est aujourd'hui pénalisante en terme de vitesse de transmission puisque celle-ci est limitée à 9600 bits/s. Cette interface physique n'est donc pas adaptée pour les transferts rapides de données.

Or, pour permettre des gains de productivité plus importants sur les lignes de production, une liaison physique plus rapide est nécessaire.

Ainsi, la liaison série de type UART est de plus en plus remplacée par un autre média de communication qui est le bus CAN, référencé 6 sur la figure 1 et qui communique avec le microprocesseur du circuit via le module d'interface CAN 7.

En effet, un bus fonctionnant selon le protocole CAN permet d'atteindre des débits bien supérieurs à la liaison série asynchrone classique puisque les différents débits que permet le bus CAN s'échelonnent de 125 Kilobit/seconde à 1 Mégabit/seconde, en passant par le débit intermédiaire de 500 Kilobits/seconde.

Le problème qui se pose alors est de pouvoir programmer les flash vierges en utilisant ce média de communication et donc de pouvoir télécharger du code directement à travers le bus CAN et de pouvoir l'exécuter quelles que soient les conditions de fréquence du système et quel que soit le débit binaire sur la liaison.

Des solutions sont d'ores et déjà proposées dans l'art antérieur, notammament la société ATMEL a développé un microcontrôleur dédié spécifiquement aux applications mettant en oeuvre un réseau CAN. Cependant, la solution développée par ATMEL n'est pas totalement satisfaisante puisqu'elle nécessite des ressources matérielles supplémentaires, notamment au niveau du module CAN, pour la gestion des erreurs.

L'invention cherche au contraire à éviter cet inconvénient de mettre en oeuvre des ressources matérielles en sus.

Il est important de noter dès maintenant que l'invention est destinée à s'appliquer aussi bien à un contexte où les mémoires flash de tous les modules à programmer sont vierges, qu'à un contexte où les flash ne sont pas vierges, c'est-à-dire un contexte où il y a déjà un programme identique installé dans tous les modules, c'est le cas notamment lorsqu'une première programmation d'un logiciel de test a été installée dans la mémoire flash et qu'il est alors nécessaire de reprogrammer la flash. Il est également connu du document de brevet EPA-1 100 091, un procédé de programmation de mémoires reprogrammables embarquées, consistant à programmer en parallèle la mémoire embarquée d'une pluralité de modules via un bus à accès multiples auxquels les modules sont connectés.

Cependant, dans un contexte de reprogrammation de la flash, c'est-à-dire dans un contexte où un programme identique d'un logiciel de test avait déjà été installé dans la mémoire flash de tous les modules, il est nécessaire de prévoir une étape d'effacement préalablement à la reprogrammation des flash souhaitée par l'utilisateur.

Or, l'étape d'effacement préalable à la reprogrammation est très coûteuse en temps, puisqu'elle s'étale sur une durée de l'ordre de la dizaine de secondes par circuit. Cet aspect effacement de la mémoire, indispensable à la mise en oeuvre ultérieure de la reprogrammation, est un handicap très lourd dans un environnement de production qui doit produire plusieurs centaines de milliers voire plusieurs millions de modules.

Enfin, pour ce qui est de la programmation en elle-même des mémoires flash, une autre contrainte dont il faut tenir compte est intrasèque au composant, puisque programmer une flash revient à charger des condensateurs. En effet, une flash est constituée d'une pluralité de petits condensateurs dotés chacun d'un isolant de très bonne qualité, ce qui fait qu'ils ne se déchargent quasimment pas au cours du temps.

Cependant, en fonction de la variation de la qualité d'oxyde des lots de fabrication, les condensateurs vont se décharger plus ou moins vite. Ainsi, si la programmation d'une flash prend x microsecondes pour un circuit donné, elle peut prendre par exemple 1 microseconde de plus pour un autre circuit, du fait de ces variations de la qualité d'oxyde.

Ces problèmes de synchronisation qui se posent entre les différents modules, dus à la programmation de la flash et qui sont intrasèques aux flash elles-même, apparaîssent comme un défaut rédhibitoire pour la mise en place d'un protocole spécifique de programmation via le bus CAN.

Aussi, un des buts que se propose d'atteindre la présente invention est de s'affranchir des contraintes liées à la flash pour résoudre le problème de l'asynchronisme dû à la programmation de la flash, permettant ainsi une programmation ainsi qu'une reprogrammation parallèle au niveau module des flash embarquées via le bus CAN.

Dans un contexte particulier où les flash à programmer sont vierges, un autre but de l'invention est de démarrer le microprocesseur directement à travers le bus CAN sans utiliser de matériel supplémentaire, quelle que soit la fréquence du système et quel que soit le débit binaire de la transmission de données sur le bus CAN, tout en restant compatible avec les méthodologies de démarrage classique qui sont mises en oeuvre par l'intermédiaire de la liaison série de type UART. En effet, une fois que le démarrage via le bus CAN est rendu réalisable, il devient possible d'envisager la programmation en parallèle des flash au niveau module.

Le principe de l'invention décrit dans la présente demande pour un bus CAN est néammoins applicable à tout bus de type à accès multiples comme par exemple le nouveau bus automobile TTP, pour «Time Triggered Protocol», le bus selon la norme américaine J1850 ou bien encore le bus VAN.

Pour sa mise en oeuvre, un protocole spécifique de communication permettant l'envoi simultané des mêmes données à tous les modules pour la programmation et la reprogrammation en parallèle des flashes embarquées a dû être défini.

De façon avantageuse, pour gérer l'asynchronisme dû à la programmation de la flash, la connectique existante des modules est utilisée pour passer à chacun d'eux une configuration unique. Ainsi, chacun des modules peut s'identifier individuellement, la station de programmation pouvant alors savoir combien de modules sont connectés.

Ce faisant, plusieurs circuits ou modules peuvent être programmés ou reprogrammés en parallèle, ce qui permet des gains de productivité très importants au niveau des lignes de production et donc des coûts réduits.

L'invention est définie par la revendication 1.

Les caractéristiques et avantages de la présente invention apparaîtront plus clairement à la lecture de la description suivante d'un exemple particulier de réalisation se rapportant à l'utilisation d'un bus CAN et faite en référence aux figures annexées, données à titre d'exemple non limitatif, dans lesquelles :
- la figure 1 est un schéma fonctionnel d'un module contenant la mémoire flash à programmer ;
- la figure 2 montre un exemple de la configuration matérielle d'un banc de programmation des modules.

Pour ce qui est tout d'abord de la séquence de démarrage à mettre en oeuvre lorsque des flash vierges doivent être programmées, on utilise la ressource matérielle intégrée qu'est le chronomètre, référencé 4 sur la figure 1. Le chronomètre 4 est activé par un dérivé de la fréquence interne du système et son rôle va être de mesurer la durée de transmission d'une trame prédéfinie comprenant un nombre prédéterminé d'éléments binaires.

En mesurant la durée de transmission d'un certain nombre de transitions à travers la fréquence interne du système, le débit binaire exact du CAN peut être calculé précisément. Ainsi, le microprocesseur 1 va pouvoir être adapté à la fréquence du CAN. Le module CAN 7 du circuit est alors configuré pour participer activement à la communication.

Une première phase consiste donc à détecter le débit binaire sur le CAN.

La détection du débit binaire est basée sur la mesure temporelle d'une trame prédéfinie transmise sur le CAN par une station de programmation 9. Pendant le temps de la mesure, le module CAN 7 du circuit n'est pas actif. La détection va en fait s'opérer au niveau des ports d'entrée/sortie du circuit. Ainsi, le microprocesseur va recevoir et analyser la trame prédéfinie via les ports d'entrée/sortie (non représentés à la figure 1) au lieu de travailler directement avec le module CAN.

Le microprocesseur mesure le temps de transmission sur une trame de référence comportant un nombre important de bits, de préférence 29 bits, de façon à obtenir une bonne résolution. On cherche en effet à avoir le plus grand nombre de bits possible, mais tout en faisant en sorte que le logiciel ait un nombre de transitions réduit à contrôler. Au-delà de 29 bits, il y a beaucoup de transitions et il devient alors plus difficile de suivre les transitions avec le logiciel avec n'importe quelle fréquence.

Puis, le débit binaire équivalent est calculé par le microprocesseur 1, ce qui permet de configurer le module CAN 7 correctement et de donc de renvoyer à destination de la station de programmation 9, par l'intermédiaire du module CAN 7, une trame d'identification prédéfinie valide sur le bus CAN 6 faisant office d'accusé de réception.

Une deuxième phase consiste alors à télécharger le programme de chargement.

Pour ce faire, la station de programmation 9 va envoyer sur le bus CAN 6 un nombre prédéfini d'octets, typiquement 32 octets, à destination du microprocesseur 1 via le module CAN. Selon un mode de réalisation particulier, on charge un nombre plus important d'octets, par exemple 64, de façon à pouvoir réinitialiser le module CAN avec les paramètres optimum définitifs du CAN. En faisant ainsi passer les paramètres définitifs du CAN avec les octets qui sont téléchargés dans le microprocesseur, le procédé gagne en robustesse.

Le microprocesseur va alors charger ces octets dans sa mémoire interne qui est une mémoire volatile de type RAM (acronyme pour l'expression anglo-saxonne Random-Access Memory). Une fois que le microprocesseur a écrit le nombre suffisant d'octets dans la RAM, il va exécuter le programme qui vient d'être chargé et envoyer une trame prédéfinie signifiant la fin de deuxième phase, accusant ainsi réception des octets à la station de programmation via le module CAN.

On a donc réussi à charger un embryon de programme, qui est totalement configurable. De façon avantageuse, cet embryon de programme est un programme de chargement qui va permettre par la suite de charger un nombre beaucoup plus important d'octets.

Ainsi, dans une troisième phase, une application finale peut être téléchargée à partir de la station de programmation dans la RAM du microprocesseur. Cette application finale peut par exemple être un logiciel de programmation de la flash.

Pour démarrer, un programme initial permettant de charger la mémoire interne des microprocesseurs de chacun des modules a donc pu être téléchargé par l'intermédiaire du bus CAN grâce à la détection préalable du débit binaire sur le CAN au niveau module.

Une fois que le démarrage du système via le bus CAN est réalisé, il devient possible de mettre en oeuvre la programmation et l'effacement en parallèle de mémoires flash par bus CAN.

Ainsi, sur la figure 2, à titre d'exemple, seuls deux modules à programmer (ou à reprogrammer) M0 et M1 sont représentés. Il est cependant clair que l'invention est destiné à s'appliquer à une pluralité de modules. Les modules M0 et M1 communiquent avec la station de programmation 9 par l'intermédiaire du bus CAN 6. Tous les modules connectés au bus CAN travaillent à la même fréquence et fonctionnent avec le même logiciel.

Ainsi, dans un premier temps, les états prédéfinis d'entrée et sortie des modules doivent être lus par l'utilisateur afin de définir un identifiant spécifique au module qui sera par la suite utilisé pour communiquer avec la station de programmation à travers le CAN. Pour ce faire, on utilise la connectique existante des modules, respectivement 10, I1, pour fournir en environnement de test un numéro d'identification binaire qui sera lu par le microprocesseur du module pour s'identifier auprès de la station de programmation.

Une autre approche pour permettre à chaque module d'avoir un identifiant unique (condition nécessaire pour pouvoir faire de la programmation parrallèle) est de mettre les modules séquentiellement sous tension et de les démarrer séquentiellement. Lors du démarrage, la station de programmation peut alors donner un identifiant au module.

Ensuite, elle demande au module de se mettre en attente d'un message spécifique de fin de séquence. La station continue alors à mettre sous tension et à démarrer les modules suivants. Lorsque cette phase est finie, elle envoie le message de fin de séquence : toutes les modules se retrouvent donc avec un identifiant différent et sont prêts à accepter des messages de type broadcast.

Deux types de message se distinguent dans le protocole de communication selon l'invention. Tout d'abord on trouve des messages de type « broadcast », c'est-à-dire qu'on diffuse de l'information à la fois à tous les modules connectés sur le bus CAN. Ces messages de type «broadcast» sont donc des messages à diffusion générale envoyés par la station de programmation et qui sont écoutés simultanément par tous les modules en parallèle. Ainsi, des commandes de programmation, d'effacement et de vérification sont diffusées à partir de la station de programmation. Ces commandes sont diffusés avec un identifiant générique qui permet de distinguer ces commandes de type «broadcast».

On trouve également des messages de type point à point via les identifiants propres à chacun des modules qui sont, soit des messages de la station de programation vers un module en particulier, soit des messages d'un module vers la station de programmation.

L'invention prévoit donc un ensemble de règles qui couvrent les caractéristiques fonctionnelles de la liaison de transmission de données, ainsi que les procédures de transmission de données pour la programmation/reprogrammation parallèle des flash.

Dans une première étape, la station de programmation compte combien de modules sont connectés au bus. En fait, la station de programmation, par l'intermédiaire d'une commande de type «broadcast», demande aux modules de s'identifier eux-même et d'envoyer leur trame d'identification.

Puis, dans une deuxième étape, la station de programmation diffuse des commandes de programmation à destination de tous les modules en parallèle (ou une commande d'effacement dans le cas d'une reprogrammation). Ces commandes de programmation interprétées comme étant de type «broadcast» grâce à l'identifiant générique auquel elles sont associées comprennent une adresse d'écriture et une donnée à programmer.

De façon optionnelle, quand la programmation est terminée, la station de programmation répète la même procédure et diffuse une commande de vérification, à nouveau à destination de tous les modules. Ainsi, par l'intermédiaire d'un unique message de type « broadcast » qui comprend l'adresse et la donnée de référence, chacun des modules s'auto-vérifie par l'intermédiaire de son microprocesseur en comparant lui-même le contenu de sa flash avec la référence qu'il a reçu. La vérification se fait donc en parallèle, faisant gagner ainsi un temps important.

Selon un mode particulier de réalisation, a la fin de la séquence, la station de programmation demande à chaque module d'envoyer les résultats de la programmation et de la vérification. En effet, chaque module enregistre ses erreurs pendant qu'il est en programmation ou pendant qu'il vérifie.

La station de programmation peut alors compter combien de modules ont été bien programmés, toujours par l'intermédiaire d'une commande de type « broadcast ».

Cependant, selon un autre mode de réalisation, chaque module peut faire part immédiatement de ses erreurs à la station de programmation dès qu'il a détecté une erreur au cours de la programmation ou au cours de la vérification, par l'intermédiaire de messages de type point à point prévus à cet effet.

De façon aditionnelle, en fonction du type de matériel de l'utilisateur, il peut être avantageux d'utiliser une sortie du module pour piloter des indicateurs externes tels que des LEDs (acronyme pour l'expression anglo-saxonne Light Emitting Diode) dont la fonction est d'indiquer le résultat de la programmation sur le banc de programmation.

A partir de deux modules à programmer en parallèle, un gain de temps important est observé par rapport à la programmation des flash par l'intermédiaire de l'UART. Ce gain de temps est encore davantage significatif si une étape d'effacement a dû être mise en oeuvre. C'est le cas notamment lorsqu'on veut par exemple charger un programme test qui sera ensuite effacé avant de programmer l'application voulue.

Le protocole vise donc à minimiser le traitement logiciel nécessaire dans le module, de manière à ce que le microprocesseur du module passe plus de temps à faire de la programmation qu'à gérer la communication avec la station de programmation.

Pour ce faire, un système de double tampon est mis en place pour permettre simultanément la réception de données et la programmation dans la mémoire. Ainsi,dans un premier temps, les commandes de programmation reçues du CAN sont mises dans une première zone tampon faisant office de zone d'attente.

Puis, à la réception par chacun des modules d'une commande de transfert de tampon et de programmation, la programmation de la flash débute dans chacun des modules à partir des données stockées dans la première zone tampon de données qui était jusqu'alors en réception et, simultanément, une deuxième zone tampon est allouée à la réception des commandes du CAN. I1 y a donc un premier processus de remplissage d'un tampon de données et un processus de traitement de ces données. Le basculement d'un processus à l'autre permet d'être très efficace en terme de programmation des modules avec un minimum de communication, et donc un gain de temps optimal.

Pour minimiser encore le traitement logiciel nécessaire dans le module pour le traitement des communications module-station de programmation, de gros tampons doivent être mis en oeuvre. En effet, pour passer d'un tampon à un autre, une commande de transfert va être envoyée de la station de programmation au module. De même, chacun des modules va envoyer un message de rapport à la station de programmation lorsqu'il aura fini de programmer le tampon.

Voyons maintenant en détail l'ensemble des commandes prévues dans le protocole selon l'invention.

Le protocole, autorisant la programmation de mémoire flash en parallèle via le bus CAN, met donc tout d'abord en oeuvre un certain nombre de commandes de type « broadcast », c'est-à-dire que ce sont des commandes diffusées de la station de programmation à destination de tous les modules connectés sur le bus CAN et n'importe lequel des modules peut les recevoir.

Une première commande envoyer_ID consiste à demander aux modules d'envoyer leur identifiant. Chaque module doit donc envoyer son identifiant qui lui est propre, ce qui permet à la station de programmation de compter le nombre de modules qui sont connectés à lui via le bus CAN et de les suivre individuellement.

Une autre commande de type « broadcast » est la commande de démarrage de remplissage de tampon. Cette commande se traduit par l'émission sur le CAN à destination de tous les modules d'une adresse mémoire de départ, d'un compte et des données à écrire dans la mémoire à ladite adresse. Par exemple, le compte permet de signifier au module combien de mots binaires il va recevoir après avoir reçu la commande de remplissage de tampon.

Par la suite, des commandes de continuation de remplissage de tampon sont diffusées qui ne comprennent que des données et l'adresse de mémoire s'auto-incrémente automatiquement. Ainsi, il est possible de minimiser le nombre de bits auxiliaires à transmettre et donc le temps d'émission des données.

Chacun des modules reçoit donc des données jusqu'à ce qu'il reçoive une nouvelle commande de démarrage de remplissage de tampon, ou bien jusqu'à ce qu'il reçoive une commande de transfert de tampon et de programmation, à l'initiative de la station de programmation.

La commande de transfert de tampon et de programmation consiste à demander à chaque module de démarrer la programmation à partir du tampon qui était en réception de données et à allouer l'autre tampon à la réception. Ainsi, le tampon qui était en réception devient le tampon qui va servir de référence à la programmation et celui qui était en programmation devient le tampon de réception.

La commande pendante de la commande précédente de transfert de tampon et de programmation est la commande de transfert de tampon et de vérification, qui est également une commande de type « broadcast ». A la réception de cette commande, chacun des modules démarre la vérification à partir du tampon qui était en réception et l'autre tampon est alors alloué à la réception. La vérification s'opère donc à partir d'une seule commande diffusée à tous les modules en même temps et chaque module vérifie lui-même le résultat de sa programmation. On est donc dans le cadre d'une vérification de type « broadcast », induisant un gain de temps important sur tout le processus.

Les commandes de démarrage de remplissage de tampon et de continuation de remplissage de tampon sont en fait indépendantes aussi bien des commandes de programmation que des commandes de vérification. C'est simplement lorsqu'on transfère les tampons que l'on signifie si la commande de transfert est pour programmer ou bien pour vérifier.

Une autre commande diffusée par la station de programmation vers tous les modules est prévue selon le protocole et consiste à demander l'envoi d'une information indicatrice d'état pour chaque module. Chacun des modules envoie alors son état de programmation suite à la vérification par exemple.

Enfin, une dernière commande diffusée (de type « broadcast ») est nécessaire, c'est la commande d'effacement. La commande d'effacement diffusée par la station de programmation sur le bus CAN où sont connectés tous les modules permet de lancer l'effacement de la mémoire pour tous les modules en même temps. Cette commande intervient notamment dans le cadre d'une reprogrammation parallèle des mémoires flash via le bus CAN.

Suivant l'implémentation choisie pour le protocole, la commande d'effacement est de préférence mise en oeuvre en deux étapes pour plus de sécurité. Ainsi, une première commande de préparation d'effacement consiste à passer en paramètre les banques de données devant être effacées dans la mémoire flash, puis une deuxième commande de confirmation d'effacement consiste à exécuter la commande précédente. La commande de confirmation d'effacement peut évidemment être optionnelle.

Le protocole selon l'invention met également en oeuvre un certain nombre de messages spécifiques des modules vers la station de programmation. Il ne s'agit donc plus de messages de type « broadcast » comme précédemment, mais des messages de type point-à-point.

Pour que la communication entre chacun des modules et la station de programmation soit possible, il est nécessaire d'avoir des identificateurs spécifiques pour chacun des messages du type précité.

Un identificateur global sur le CAN est un identificateur de type à 11 bit minimum. Parmi ceux-ci, certains définissent le type de commande et d'autres définissent le numéro du module. Les identificateurs spécifiques sur le bus CAN à utiliser dans ce cas sont issus d'une combinaison logique entre les identificateurs génériques alloués pour chaque commande et l'identifiant propre du module, de manière à ce qu'il y ait un identificateur unique envoyé sur le CAN pour chacun des messages d'un module vers la station de programmation.

Une commande importante à prévoir parmi ces commandes spécifiques point-à-point des modules vers la station de programmation est la commande conunand_OK. La commande command_OK est envoyée par chacun des modules à la station de programmation après une programmation/vérification réussie de son tampon de données (ou après un effacament réussi).

De façon avantageuse, sachant qu'un certain asynchronisme dû à la programmation des flash doit être géré, la station de programmation démarre une temporisation de manière à laisser l'opportunité à chacun des modules de programmer correctement (ou de vérifier) sa mémoire. Au bout d'un certain temps prédéfini par la station de programmation, celle-ci va renvoyer une commande individuelle, grâce à l'dentification unique pour chacun des modules, à tous les modules qui n'ont pas répondu pour leur signifier qu'ils sont en état d'erreur.

Cependant, les commandes point-à-point disponibles des modules vers la station de programmation peuvent également comprendre une commande d'erreur de programmation. Ainsi, lorsqu'un module détecte une erreur en cours de programmation (quand il n'arrive pas à écrire une valeur par exemple), cette commande d'erreur de programmation lui donne la possibilité de signaler immédiatement cette erreur à la station de programmation avant la fin de la temporisation.

De la même manière, une commande d'erreur de vérification est prévue qui donne l'opportunité à chacun des modules de reporter à la station de programmation une erreur de vérification dès l'instant où il la détecte, et non tout à la fin du processus de vérification.

La station de programmation quant à elle démarre la temporisation et attend que tous les modules lui envoient soit la commande command_OK, soit un message d'erreur.

Ces commandes d'erreur de programmation et d'erreur de vérification émises dès détection de l'erreur permettent en fait d'optimiser les temps de programmation. En effet, grâce à ces différentes commandes, la station de programmation n'a pas besoin d'attendre la fin de la temporisation pour traiter les éventuelles erreurs. Ceci est rendu possible encore une fois grâce à l'identifiant unique alloué à chacun des modules connectés sur le bus CAN.

Dans le cas d'un effacement en vue d'une reprogrammation ultérieure de la mémoire flash, une commande d'erreur d'effacement peut aussi être mis en oeuvre, selon le même principe et dans le même but que les commandes d'erreur de programmation et d'erreur de vérification mises en oeuvre au cours de la programmation parallèle des différents modules.

Une dernière commande point-à-point spécifique des modules vers la station de programmation est la commande d'état du module. Cette commande est envoyé par chacun des modules en réponse à une requête (de type « broadcast ») de la station de programmation en ce sens.

Le protocole selon l'invention prévoit également des commandes spécifiques de la station de programmation à destination des modules. Il s'agit donc à nouveau de commandes point-à-point.

De la même façon que pour les commandes spécifiques des modules vers la station de programmation, il faut générer des identificateurs spécifiques sur le CAN afin que chaque module puisse savoir si le message le concerne. Pour ce faire, les identificateurs génériques qui sont mis en oeuvre pour les différentes commandes prévues vont être particularisés en mettant à la fin de chacun d'eux l'indice spécifique du module auquel la commande s'adresse, permettant ainsi la communication point-à-point et par la même l'émission de messages spécifiques de la station de programmation vers les modules.

Parmi ces messages spécifiques de la station de programmation vers les modules, la commande d'envoi d'état consiste à demander à un module d'envoyer son état.

Une commande d'arrêt consiste à demander à un module d'arrêter toute opération immédiatement. Cette commande peut permettre d'éviter que les modules qui ont des erreurs dans la programmation de la flash viennent troubler la programmation des autres modules.

Une commande d'arrêt de la temporisation signifie aux modules dont la réponse est attendue, sous la forme d'un message spécifique module vers station de programmation du type par exemple de la commande command_OK vue précédemment, que la temporisation mise en oeuvre dans la station de programmation est terminée. Après avoir reçu cette commande d'arrêt de la temporisation, le module en question doit se considérer lui-même en état d'erreur.

A la fin de la programmation ou de la vérification (ou encore à la fin de l'effacement lorsqu'un processus de reprogrammation parallèle est mis en oeuvre), une commande opération OK doit être prévue. Cette commande point-à-point opération_OK est la traduction du fait que la station de programmation reste le garant que tout s'est bien passé au niveau d'un module spécifique. En dernier lieu, c'est la station de programmation qui confirme à chacun des modules qu'il est bien programmé, même si à travers une commande de type « broadcast » vue plus haut dans la description, la station de programmation délègue la vérification de la programmation à chacun des modules, chaque module reportant par la suite le résultat de sa vérification à la station de programmation.

La réception de cette commande opération_OK peut avntageusement être utilisé par le module pour commander une diode luminescente sur un des ports de sortie existants du module.

Ainsi, d'un point de vue protocole, la station de programmation vérifie qu'elle a bien reçu tous les accusés de réception de chacun des modules et signifie alors par l'intermédiaire de la commande opération_OK à chacun des modules spécifiques que tout s'est bien déroulé tout au long du processus.

Après avoir décrit l'ensemble des commandes, spécifiques et de type « broadcast », prévues par le protocole selon l'invention, prenons maintenant un exemple d'un flot de programmation et de vérification mettant en oeuvre ces différentes commandes. Toutes les commandes transitent sur le bus CAN indépendamment de qui les envoie.

Une première étape met donc en jeu la commande envoyer_ID émis par la station de programmation, et chacun des modules répond en envoyant son identifiant spécifique.

Une deuxième étape consiste à envoyer la commande de début de remplissage de tampon, qui marque le début de la réception sur un tampon. Dans une troisième étape, la commande de continuation de remplissage de tampon est envoyé sur le CAN, on continue alors de remplir le tampon avec une incrémentation des adresses.

Une quatrième étape met en oeuvre, soit d'autres commandes de continuation de remplissage de tampon, soit une nouvelle commande de début de remplissage de tampon dans le cas où il y a une discontinuité au niveau des adresses des données à programmer.

Dans une cinquième étape, la commande de transfert de tampon et de programmation est envoyée. La programmation débute alors dans chacun des modules à partir du tampon qui était en réception et simultanément, le deuxième tampon est alloué à la réception. La commande de transfert de tampon et de vérification peut également être mise en oeuvre au cours de cette étape, une vérification est alors lancée, et cette vérification a lieu dans chacun des modules en parallèle, comme déjà expliqué.

Une sixième étape consiste à répéter les commandes de remplissage de tampon. Ainsi, les étapes 2 à 5 se répètent jusqu'à la fin du processus de programmation.

Dans une septième étape, chaque module envoie alors en parallèle, soit la commande command_OK qui indique le traitement réussi des données du dernier tampon, soit la commande d'erreur de programmation qui indique une erreur au cours de la programmation, soit la commande d'erreur de vérification qui indique une erreur au cours de la vérification.

La huitième étape consiste à envoyer depuis la station de programmation la commande d'arrêt de la temporisation. Cette commande met fin à la temporisation mise en oeuvre dans la station de programmation qui détermine le laps de temps au cours duquel les modules doivent effectuer leur programmation. Les modules qui reçoivent cette commande d'arrêt de temporisation doivent se considérer en erreur.

Enfin la dernière étape du processus de programmation et de vérification consiste à envoyer la commande operation_OK. La station de programmation peut alors confirmer via cette commande à chacun des modules individuellement que tout s'est bien passé tout au long du processus.

Dans le cas d'un effacement des mémoires flash des modules en vue d'une reprogrammation en parallèle, le flot des commandes sur le CAN est plus simple.

Une première étape consiste à mettre en oeuvre la commande envoyer_ID, chacun des modules répond en envoyant son identifiant spécifique et la station de programmation peut alors compter le nombre de modules à effacer.

L'effacement a lieu de préférence en deux étapes par l'intermédiaire de deux commandes de type « broadcast » . : une commande de préparation de l'effacement et une commande de confirmation de l'effacement.

Les modules envoient alors, soit une commande du type de la commande command_OK indiquant qu'ils ont bien exécuté la commande d'effacement, soit une commande d'erreur d'effacement.

Si l'effacement s'est bien déroulé par tous les modules, la commande opération_OK est envoyée. Par cette commande, la station de programmation confirme spécifiquement à chacun des modules que l'effacement est un succès. Cette commande est donc envoyée en réponse à la commande command_OK issue des modules.

Enfin, dans une dernière étape, la commande d'arrêt de la temporisation est mise en oeuvre. Les modules qui n'ont pas répondu pendant cette temporisation et qui reçoivent donc cette commande doivent se mettre en erreur.

Le protocole selon l'invention définit donc des règles pour écrire un logiciel qui permet la programmation parallèle d'une flash embarquée vierge ou non vierge d'une pluralité de modules à travers le bus auquel les modules sont connectés. La définition de ce protocole est rendue possible par l'utilisation de ports d'entrée/sortie existants des modules pour passer à chacun des modules une configuration unique. Une combinaison logique peut alors être opérée entre des identifiants qu'on alloue au bus CAN pour des types de commande et les identifiants spécifiques à chacun des modules pour rendre possible la communication selon le protocole.

Dans le cas de flash vierges, l'invention définit également un procédé qui permet de télécharger du code à travers le bus et de l'exécuter, en s'affranchissant de toutes les contraintes extérieures (fréquence, débit binaire).

L'exemple de réalisation qui vient d'être décrit fait plus particulièrement référence à l'utilisation d'un bus CAN. Toutefois, l'invention ne se limite pas à l'utilisation d'un bus CAN et tout autre bus à accès multiples non dédié à cet effet peut être mis en oeuvre dans la programmation en parallèle de flash embarquées sur module. Pour cela, il suffit que le bus en question soit accessible en parallèle, que ce soit par nature ou que le protocole soit modifié d'une façon connue en soi pour qu'il le devienne (conditions d'accès au bus, redéfinition des en têtes de message pour permettre des message de type «broadcast»...

Comme déjà vu, le procédé selon l'invention tel que décrit en référence à l'exemple d'utilisation du bus CAN en fait applicable à tout bus de type à accès multiples comme le nouveau bus automobile TPP, le bus selon la norme américaine J1850, le bus VAN...

## Revendications

1. Procédé de programmation ou reprogrammation de mémoire reprogrammable embarquée (5), consistant à programmer ou reprogrammer en parallèle la mémoire embarquée d'une pluralité de modules (M0, M1 ...) par l'intermédiaire d'un bus à accès multiples (6) auquel lesdits modules sont connectés, **caractérisé en ce qu'**il consiste à définir un protocole de communication sur le bus (6) mettant en oeuvre des commandes de type « broadcast » diffusées par une station de programmation (9) à destination de tous les modules et des commandes de type point-à-point, lesdites commandes de type point-à-point comprenant à la fois des commandes spécifiques des modules (M0, M1 ... ) vers la station de programmation (9) et des commandes spécifiques de la station de programmation vers les modules.

2. Procédé selon la revendication 1, **caractérisé en ce qu'**il consiste à fournir en environnement de test à chacun des modules (M0, M1 ...), en utilisant leur connectique existante (I0, I1 ...), un identifiant binaire qui lui est propre de façon à ce que chacun desdits modules puisse s'identifier auprès de la station de programmation (9) à travers le bus.

3. Procédé selon la revendication 1 ou 2, **caractérisé en ce que** les les commandes de type «broadcast» sont diffusées avec un identifiant générique qui permet de les distinguer.

4. Procédé selon l'une quelconque des revendications 1 à 3, **caractérisé en ce qu'**il consiste à générer des identificateurs spécifiques sur le bus dans le cas de la transmission de commandes de type point-à-point.

5. Procédé selon la revendication 4, **caractérisé en ce que** les identificateurs spécifiques sur le bus sont issus d'une combinaison logique entre des identificateurs génériques alloués pour chaque commande et un identifiant propre du module.

6. Procédé selon l'une quelconque des revendications précédentes, **caractérisé en ce**, lorsque la mémoire embarquée des modules à programmer n'est pas vierge, un effacement de la mémoire de tous les modules en même temps est effectuée par l'intermédiaire d'une commande de type broadcast.

7. Procédé selon la revendication 6, **caractérisé en ce que** la commande d'effacement des mémoires en parallèle est mise en oeuvre en deux étapes consistant à :
- passer en paramètre les banques de données devant être effacées dans la mémoire embarquée de chacun des modules,
- confirmer l'effacement en exécutant la commande précédente .

8. Procédé selon l'une quelconque des revendications précédentes, **caractérisé en ce qu'**il consiste à mettre en oeuvre dans le protocole un système de double tampon pour permettre simultanément au niveau des modules la réception de données et la programmation dans la mémoire.

9. Procédé selon l'une quelconque des revendications précédentes, **caractérisé en ce qu'**une vérification de la programmation est effectuée dans chacun des modules en parallèle par l'intermédiaire d'une commande de type « broadcast ».

10. Procédé selon la revendication 9, **caractérisé en ce que** la commande de vérification comprend une adresse et une donnée de référence, chacun des modules s'auto-vérifiant par l'intermédiaire de son microprocesseur (1) en comparant lui-même le contenu de sa mémoire avec la référence reçue.

11. Procédé selon la revendication 1 ou 2, **caractérisé en ce que**, dans un contexte où les mémoires embarquées (5) à programmer sont vierges, une étape préalable à la programmation est mise en oeuvre consistant à démarrer un microprocesseur (1) de chaque module (M0, M1 ...) directement à travers le bus (6), quelle que soit la fréquence du microprocesseur et quel que soit le débit binaire sur le bus.

12. Procédé selon la revendication 11, **caractérisé en ce que** la séquence de démarrage comprend les phases suivantes consistant à :
a- détecter le débit binaire sur le bus,
b- télécharger un programme de chargement dans une mémoire interne du microprocesseur (1),
c- télécharger une application finale dans la mémoire interne du microprocesseur (1).

13. Procédé selon la revendication 12, **caractérisé en ce que** la phase a- comprend les étapes suivantes consistant à :
- mesurer le temps de transmission d'une trame prédéfinie transmise sur le bus comportant un nombre de bits adapté à obtenir une bonne précision,
- calculer le débit binaire équivalent.

14. Procédé selon la revendication 12 ou 13, **caractérisé en ce que** la phase b-consiste à envoyer sur le bus à destination du microprocesseur (1) un nombre prédéfini d'octets comprenant les paramètres optimum définitifs du bus (6).

15. Procédé selon l'une quelconque des revendications précédentes **caractérisé en ce qu'**il s'applique plus particulièrement à des mémoires embarquées de type flash.

16. Procédé selon l'une quelconque des revendications précédentes, **caractérisé en ce qu'**il est mis en oeuvre par l'intermédiaire d'un bus CAN.

17. Procédé selon l'une quelconque des revendications 1 à 15 **caractérisé en ce qu'**il est mis en oeuvre par l'intermédiaire d'un bus TPP.

18. Procédé selon l'une quelconque des revendications 1 à 15 **caractérisé en ce qu'**il est mis en oeuvre par l'intermédiaire d'un bus selon la norme américaine J1850.

19. Procédé selon l'une quelconque des revendications 1 à 15 **caractérisé en ce qu'**il est mis en oeuvre par l'intermédiaire d'un bus VAN.

## Claims

1. Method for programming or reprogramming an onboard reprogrammable memory (5), consisting of programming or reprogramming the onboard memory of several modules (M0, M1,...) in parallel, using a multiple access bus (6) to which the said modules are connected, **characterised in that** it consists of defining a communication protocol on the bus (6) using "broadcast" type commands broadcast by a programming station (9) to all modules, and point-to-point type commands, the said point-to-point type commands comprising specific commands from modules (M0, M1 ...) to the programming station (9), and specific commands from the programming station to the modules.

2. Method according to claim 1, **characterised in that** it consists of supplying to each module (M0, M1...) in test environment a binary identifier that is specific to said module using its existing connections (I0, I1...) , so that each of the said modules can identify itself before the programming station (9) through the bus.

3. Method according to claim 1 or 2, **characterised in that** the "broadcast" type commands are broadcast with a generic identifier that distinguishes them.

4. Method according to any one of claims 1 to 3, **characterised in that** it consists of generating specific identifiers on the bus in the case of transmission of point-to-point type commands.

5. Method according to claim 4, **characterised in that** the specific identifiers on the bus are derived from a logical combination between generic identifiers allocated for each command and an identifier specific to the module.

6. Method according to any one of the preceding claims, **characterised in that** when the onboard memory of the modules to be programmed is not blank, the memories of all modules are erased at the same time using a broadcast type command.

7. Method according to claim 6, **characterised in that** the erase memory command in parallel is implemented in two steps consisting of:
- transferring the data banks to be erased in the onboard memory of each module, as parameters,
- confirming the erasing by executing the previous command.

8. Method according to any one of the preceding claims, **characterised in that** it consists of implementing a double buffer system in the protocol to enable simultaneous data reception and programming in the memory at the level of the modules.

9. Method according to any one of the preceding claims, **characterised in that** a check of the programming is made in each module in parallel using a "broadcast" type command.

10. Method according to claim 9, **characterised in that** the verification command comprises an address and a reference data, each of the modules self checking itself through its microprocessor (1) by itself comparing the contents of its own memory with the received reference.

11. Method according to claim 1 or 2, **characterised in that** a step prior to programming is implemented in a context in which the onboard memories (5) to be programmed are blank, consisting of starting a microprocessor (1) on each module (M0, M1...) directly through the bus (6), regardless of the frequency of the microprocessor and regardless of the binary throughput on the bus.

12. Method according to claim 11, **characterised in that** the start sequence comprises the following phases consisting of:
a- detecting the binary throughput on the bus,
b- downloading a loading program into the internal memory of the microprocessor (1),
c- downloading a final application into the internal memory of the microprocessor (1).

13. Method according to claim 12, **characterised in that** phase a- comprises the following steps consisting of:
- measuring the transmission time of a predefined frame transmitted on the bus comprising a number of bits adapted so as to obtain a good precision,
- calculating the equivalent binary throughput.

14. Method according to claim 12 or 13, **characterised in that** phase b- consists of sending on the bus to the microprocessor (1) a predefined number of octets comprising the final optimum parameters for the bus (6).

15. Method according to any one of the preceding claims, **characterised in that** it is more particularly applicable to onboard flash memory type memories.

16. Method according to any one of the preceding claims, **characterised in that** it is implemented through a CAN bus.

17. Method according to any one of claims 1 to 15, **characterised in that** it is implemented through a TPP bus.

18. Method according to any one of claims 1 to 15, **characterised in that** it is implemented through a bus according to the American J1850 standard.

19. Method according to any one of claims 1 to 15, **characterised in that** it is implemented through a VAN bus.

## Patentansprüche

1. Verfahren zur Programmierung oder Umprogrammierung eines umprogrammierbaren Onboard-Speichers (5), welches daraus besteht, den Onboard-Speicher einer Vielzahl von Modulen (M0, M1 ...) mit Hilfe eines Mehrfachzugriffsbusses (6), an welchen die Module angeschlossen sind, parallel zu programmieren oder umzuprogrammieren, **dadurch gekennzeichnet, dass** es daraus besteht, auf dem Bus (6) ein Kommunikationsprotokoll zu definieren, welches Befehle der Art "Broadcast" durchführt, die von einer Programmierstation (9) in Richtung aller Module ausgesandt werden, und Befehle der Art Punkt-zu-Punkt, welche zugleich spezifische Befehle der Module (M0, M1, ...) an die Programmierstation (9) und spezifische Befehle der Programmierstation an die Module aufweisen.

2. Verfahren gemäß Anspruch 1, **dadurch gekennzeichnet, dass** es daraus besteht, an jedes der Module (M0, M1,...) unter Verwendung ihres bestehenden Anschlusses (I0, I1, ...) in Testumgebung ein binäres Kennzeichen zu liefern, das ihm derart zueigen ist, dass sich jedes der Module bei der Programmierstation (9) durch den Bus identifizieren kann.

3. Verfahren gemäß Anspruch 1 oder 2, **dadurch gekennzeichnet, dass** die Befehle der Art "Broadcast" mit einem Gattungskennzeichen ausgesandt werden, das erlaubt sie zu unterscheiden.

4. Verfahren gemäß irgendeinem der Ansprüche 1 bis 3, **dadurch gekennzeichnet, dass** es daraus besteht, in dem Fall der Übertragung von Befehlen der Art Punkt-zu-Punkt auf dem Bus spezielle Identifizierer zu erzeugen.

5. Verfahren gemäß Anspruch 4, **dadurch gekennzeichnet, dass** die speziellen Identifizierer auf dem Bus aus einer logischen Kombination aus jedem Befehl zugeordneten Gattungsidentifizierern und einem Kennzeichen, das dem Modul zueigen ist, hervorgegangen sind.

6. Verfahren gemäß irgendeinem der vorherigen Ansprüche, **dadurch gekennzeichnet, dass** wenn der Onboard-Speicher der zu programmierenden Module nicht unbenutzt ist, ein Löschen des Speichers aller Module zugleich mit Hilfe eines Befehls der Art Broadcast durchgeführt wird.

7. Verfahren gemäß Anspruch 6, **dadurch gekennzeichnet, dass** der Befehl zum parallelen Löschen der Speicher in zwei Schritten durchgeführt wird, die daraus bestehen:
- die Datenbanken, die in dem Onboard-Speicher jedes der Module gelöscht werden müssen, in einen Parameter zu überführen,
- das Löschen zu bestätigen, indem der vorherige Befehl ausgeführt wird.

8. Verfahren gemäß irgendeinem der vorherigen Ansprüche, **dadurch gekennzeichnet, dass** es daraus besteht, in dem Protokoll ein doppeltes Puffersystem durchzuführen, um im Bereich der Module gleichzeitig den Empfang von Daten und die Programmierung in dem Speicher zu ermöglichen.

9. Verfahren gemäß irgendeinem der vorherigen Ansprüche, **dadurch gekennzeichnet, dass** eine Überprüfung der Programmierung parallel in jedem der Module mit Hilfe eines Befehls der Art "Broadcast" durchgeführt wird.

10. Verfahren gemäß Anspruch 9, **dadurch gekennzeichnet, dass** der Überprüfungsbefehl eine Adresse und Referenzdaten aufweist, wobei sich jedes der Module mit Hilfe seines Mikroprozessors (1) selbst überprüft, indem es selbst den Inhalt seines Speichers mit den empfangenen Referenzdaten vergleicht.

11. Verfahren gemäß Anspruch 1 oder 2, **dadurch gekennzeichnet, dass** in einem Kontext, in dem die zu programmierenden Onboard-Speicher (5) unbenutzt sind, ein Schritt vor der Programmierung durchgeführt wird, der daraus besteht, einen Mikroprozessor (1) jedes Moduls (M0, M1, ...) direkt über den Bus (6) zu starten, und zwar unabhängig von der Frequenz des Mikroprozessors und unabhängig von der binären Datenrate auf dem Bus.

12. Verfahren gemäß Anspruch 11, **dadurch gekennzeichnet, dass** die Startabfolge die folgenden Phasen aufweist, die daraus bestehen:
a - die binäre Datenrate auf dem Bus zu erfassen,
b - ein Ladeprogramm in einen inneren Speicher des Mikroprozessors (1) fernzuladen,
c - eine Endanwendung in den inneren Speicher des Mikroprozessors (1) fernzuladen.

13. Verfahren gemäß Anspruch 12, **dadurch gekennzeichnet, dass** die Phase a- die folgenden Schritte aufweist, die daraus bestehen:
- die Übertragungszeit eines auf den Bus übertragenen, vorab definierten Rasters zu messen, welches eine Bitanzahl umfasst, die dafür eingerichtet ist, eine hohe Genauigkeit zu erzielen,
- die äquivalente binäre Datenrate zu berechnen.

14. Verfahren gemäß Anspruch 12 oder 13, **dadurch gekennzeichnet, dass** die Phase b- daraus besteht, auf den Bus, bestimmt für den Mikroprozessor (1), eine vorab definierte Byteanzahl zu senden, welche die definitiven Optimalparameter des Busses (6) aufweist.

15. Verfahren gemäß irgendeinem der vorherigen Ansprüche, **dadurch gekennzeichnet, dass** es genauer auf Onboard-Speicher der Art Flash anzuwenden ist.

16. Verfahren gemäß irgendeinem der vorherigen Ansprüche, **dadurch gekennzeichnet, dass** es mit Hilfe eines CAN-Busses durchgeführt wird.

17. Verfahren gemäß irgendeinem der Ansprüche 1 bis 15, **dadurch gekennzeichnet, dass** es mit Hilfe eines TPP-Busses durchgeführt wird.

18. Verfahren gemäß irgendeinem der Ansprüche 1 bis 15, **dadurch gekennzeichnet, dass** es mit Hilfe eines Busses gemäß der amerikanischen Norm J1850 durchgeführt wird.

19. Verfahren gemäß irgendeinem der Ansprüche 1 bis 15, **dadurch gekennzeichnet, dass** es mit Hilfe eines VAN-Busses durchgeführt wird.
